# DEMANDE DE BREVET EUROPEEN

(11) **EP 0 556 099 A1**
(43) Date de publication de la demande: **18.08.1993**
(21) Numéro de dépôt: 93400292.4
(22) Date de dépôt: 05.02.1993
(51) Int. Cl.: G01R 15/02, H01F 27/36, G01R 1/18

(54) **Capteur de courant**

(30) Priorité: 14.02.1992 FR 9201666
(71) Demandeur: ABB CONTROL Société Anonyme, F-69685 Chassieu Cédex (FR)
(72) Inventeur: Abraham, Claude, F-69006 Lyon (FR); Dupre, Eric, F-69300 Caluire (FR)
(74) Mandataire: Laget, Jean-Loup

(57) **Abrégé**

Le capteur de courant comporte un élément de mesure à sonde de Hall 3 dans un entrefer d'un tore 4 et un écran magnétique 5 disposés sensiblement à l'opposé l'un de l'autre.

## Description

L'invention concerne un capteur de courant du genre comportant un bobinage électrique autour d'un noyau torique magnétique, apte à être positionné autour d'un conducteur primaire dans lequel passe un courant électrique à détecter ou à mesurer.

De tels capteurs de courant sont couramment utilisés dans des installations telles que des armoires de distribution d'énergie électrique pour effectuer des mesures et des contrôles de fonctionnement.

Le document FR 2.564.594 décrit un capteur de courant à noyau torique amagnétique avec un bobinage secondaire constitué par un enroulement bobiné sur le noyau. Ce capteur comporte un écran électrostatique en un matériau conducteur amagnétique et un écran magnétique entourant extérieurement le noyau avec le bobinage secondaire.

On connaît également des capteurs de courant du genre comportant un noyau torique magnétique, avec un écran magnétique radialement extérieur et un écran amagnétique radialement intérieur, présentant la forme de viroles disposées radialement de part et d'autre du noyau torique.

La demande de brevet français 91 08666, non accessible au public à la date de la présente demande et déposée par la Société demanderesse, a pour objet un capteur de courant du genre comportant un noyau magnétique, dans lequel deux écrans magnétiques supplémentaires sensiblement en forme de couronnes sont disposés latéralement de part et d'autre du noyau magnétique.

Ce capteur de courant non perturbé par les courants circulant dans son voisinage est utilisable quel que soit l'environnement.

Cependant, on constate que, lors de la mesure de courants intenses de l'ordre du millier d'Ampères, l'allure de la courbe de courant captée est déformée lors de variations très rapides de courants, supérieures à 10⁸ A/s.

La déformation de la courbe de courant a une allure voisine de la déformation produite par une self : ce phénomène est appelé "effet selfique" dans la présente description.

Le but de la présente invention est de fournir un capteur de courant du genre comportant un noyau magnétique, permettant de diminuer de façon très importante l'effet selfique, voire de le supprimer totalement.

L'invention a pour objet un capteur de courant du genre comportant un bobinage électrique autour d'un noyau torique magnétique, un élément de mesure à sonde de Hall disposé dans un entrefer du noyau torique et un écran magnétique, caractérisé en ce que l'écran magnétique est contenu dans un dièdre formé par deux plans diamétraux du tore, présentant un angle d'ouverture maximale d'environ 120°, et en ce que l'écran magnétique et la sonde de Hall sont disposés sensiblement de façon diamétralement opposée l'un par rapport à l'autre.

Selon d'autres caractéristiques de l'invention :
- l'écran magnétique comporte un secteur sensiblement cylindrique et deux pièces latérales en matériau magnétique, le secteur et les pièces étant solidaires entre eux et séparés par des entrefers ;
- le secteur et les pièces latérales sont rendus solidaires au moyen de pièces en matériau amagnétique ;
- les pièces latérales sont en forme de secteurs annulaires ;
- les pièces latérales sont en forme de segments de cercles ;
- les segments de cercle correspondent à une ouverture voisine d'un quart de cercle, pour mesurer le courant d'un conducteur primaire avec des branches parallèles dont l'orientation peut varier entre une position sensiblement parallèle et une position sensiblement perpendiculaire (20) à un plan de fixation ;
- les pièces latérales recouvrent partiellement en projection le cercle de gorge du tore ;
- l'écran magnétique et l'écran électrostatique sont reliés par une liaison électrique en boucle ouverte à un potentiel de référence.

L'invention sera mieux comprise grâce à la description qui va suivre donnée à titre d'exemple non limitatif en référence aux dessins annexés dans lesquels :

La figure 1 représente une vue schématique en perspective d'un premier mode de réalisation d'un capteur de courant selon l'invention.

La figure 2 représente une vue en coupe transversale d'un écran magnétique de capteur de courant selon l'invention de la figure 1.

La figure 3 représente une vue schématique en perspective d'un deuxième mode de réalisation d'un capteur de courant selon l'invention.

La figure 4 représente une vue en perspective éclatée d'un écran magnétique de capteur selon l'invention de la figure 3.

Les figures 5 et 6 représentent des vues latérales correspondant à la figure 3.

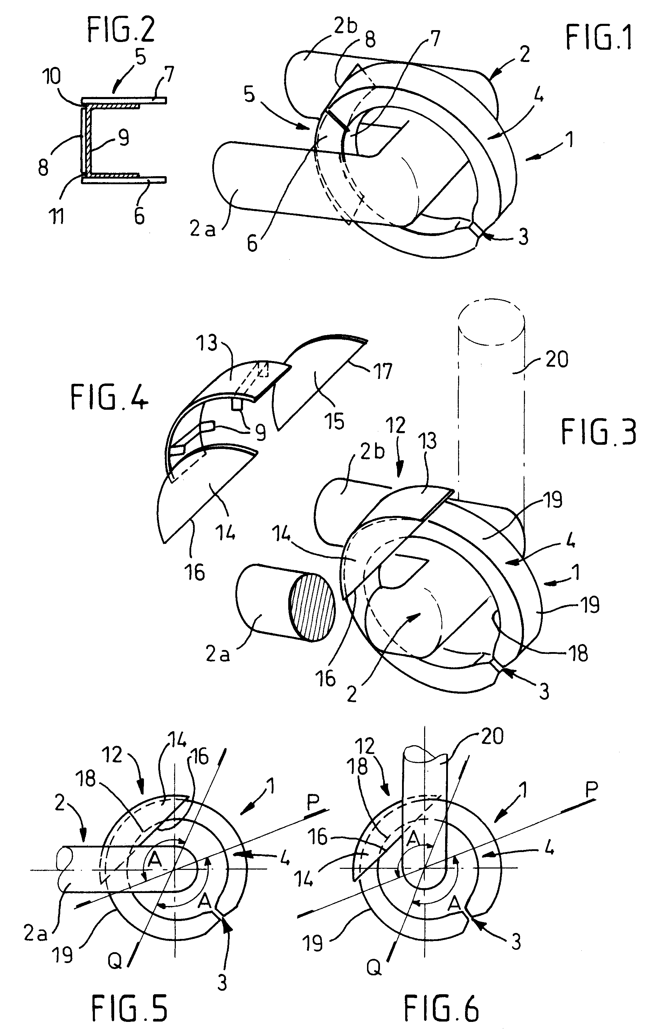

En référence à la figure 1, un capteur de courant 1 est positionné autour d'un conducteur primaire 2 dans lequel circule le courant électrique à mesurer.

Le capteur 1 représenté schématiquement comporte une sonde de Hall 3 connue en soi disposée dans l'entrefer à l'extrémité d'un noyau torique 4 en matériau magnétique entouré d'un bobinage électrique et comporte de préférence un écran électrostatique, constitué par une virole intérieure au tore en matériau conducteur amagnétique, et non représenté.

Selon l'invention, le capteur de courant 1 comporte du côté opposé à la sonde de Hall un écran magnétique 5 placé à cheval sur le tore 1 entre deux branches parallèles 2a, 2b du conducteur primaire 2.

L'écran magnétique 5 comporte deux secteurs annulaires 6 et 7 en matériau magnétique et un secteur cylindrique 8 également en matériau magnétique, solidaires entre eux.

Comme on le voit en coupe sur la figure 2, les secteurs annulaires 6 et 7 sont reliés au secteur cylindrique 8 par une ou plusieurs pièces 9 en matériau amagnétique.

Les pièces 9 en matériau amagnétique sont avantageusement en forme de cavaliers ou de U à bords parallèles, par exemple collés à l'intérieur des pièces 6, 7 et 8 en veillant toutefois à ménager des entrefers 10 et 11, respectivement entre les secteurs 7 et 8 et les secteurs 6 et 8.

Selon la variante de l'invention représentée à la figure 1, le secteur cylindrique 8 et les secteurs annulaires 6 et 7 sont limités radialement par des plans diamétraux du tore.

Selon l'invention, le dièdre limité par les plans diamétraux précités et contenant les secteurs 6, 7, 8 présente un angle d'ouverture maximale d'environ 120°.

Des essais ont montré que, si l'ouverture du dièdre correspond à plus de 120° environ, l'effet selfique subsiste lors de l'application d'échelons instantanés de courant.

En référence aux figures 3 à 6, un deuxième mode de réalisation d'un capteur selon l'invention comporte des éléments identiques à ceux de la figure 1 désignés par des chiffres de référence identiques.

Le capteur comporte un écran magnétique 12 situé au voisinage de deux branches 2a, 2b sensiblement parallèles du conducteur 2 dans lequel passe le courant à mesurer.

L'écran magnétique 12 et la sonde de Hall 3 sont disposés sensiblement de façon diamétralement opposée l'un par rapport à l'autre.

La branche 2a du conducteur primaire 2 est représentée interrompue sur la figure 3, pour faire apparaître l'écran magnétique 12 tout entier en vue perspective.

L'écran magnétique 12 comporte un secteur sensiblement cylindrique 13 et deux segments de cercle 14, 15, d'ouverture voisine d'un quart de cercle.

Les plans diamétraux P et Q du tore symbolisés aux figures 5 et 6 font entre eux un angle dièdre A de 120° environ : dans ce deuxième mode de réalisation, l'écran magnétique 12 et la sonde de Hall 3 sont situés dans deux angles opposés du dièdre formé par les plans P et Q.

Les segments de cercle 14 et 15 sont sensiblement identiques et les cordes 16 et 17 sont disposées de façon à recouvrir partiellement en projection le cercle de gorge 18 intérieur du tore (figures 5 et 6).

La courbure du secteur cylindrique 13 est adaptée pour s'appliquer sur le contour extérieur 19 du tore isolé au moins extérieurement pour empêcher tout court-circuit électrique ou magnétique, selon une disposition sensiblement coaxiale.

Dans les montages habituellement utilisés en électricité de puissance, les conducteurs primaires où passe le courant à mesurer se présentent sous forme de barres en métal conducteur disposées suivant des branches parallèles telles que 2a, 2b raccordées entre elles par une branche entourée par le tore.

Le montage se fait en général parallèlement ou perpendiculairement à un plan de pose non représenté : les directions des branches parallèles peuvent être parallèles au plan de pose dans le cas de branches 2a, 2b ou perpendiculaires dans le cas des branches 20 représentées aux figures 3 et 6.

Le deuxième mode de réalisation de l'écran magnétique, avec des segments de cercle 14 et 15 correspondant à une ouverture voisine ou supérieure à un quart de cercle, est particulièrement adapté aux deux types de montage utilisés dans l'industrie ; selon la figure 5, l'extrémité inférieure de l'écran 12 est placée entre les branches 2a, 2b et, selon la figure 6, l'extrémité supérieure de l'écran est placée entre des branches 20 : dans les deux cas, les essais ont montré l'efficacité de l'écran magnétique selon l'invention.

L'écran 12, constitué par assemblage de segments 13, 14, 15 de tôle en matériau magnétique tel que du fer ou du ferrosilicium à l'aide de cavaliers 9 en matériau amagnétique tel que du cuivre, de l'aluminium ou une matière plastique rigide, est de préférence mis à un potentiel de référence au moyen de liaisons électriquement conductrices, selon une technique connue en soi.

Dans le cas où le capteur de courant comporte ne virole intérieure en matériau conducteur amagnétique constituant un écran électrostatique connu en soi, il est avantageux de prévoir un entrefer entre l'écran magnétique selon l'invention et l'écran électrostatique et de veiller à raccorder par une liaison électrique l'écran magnétique selon l'invention et l'écran électrostatique à un potentiel de référence par une liaison électrique en boucle ouverte.

Des essais réalisés avec le capteur de courant de l'invention ont montré que la forme d'onde, correspondant à un échelon de courant de 1000A était captée avec une erreur relative de l'ordre de un pour cent, tandis que, pour les capteurs de courant de type connu, l'effet selfique conduisait à des déformations d'onde de courant captée de l'ordre de dix pour cent.

## Revendications

**1. -** Capteur de courant du genre comportant un bobinage électrique autour d'un noyau torique magnétique, un élément de mesure à sonde de Hall disposé dans un entrefer du noyau torique et un écran magnétique, caractérisé en ce que l'écran magnétique (5, 12) est contenu dans un dièdre formé par deux plans diamétraux (P, Q) du tore, présentant un angle d'ouverture maximale d'environ 120°, et en ce que l'écran magnétique (5, 12) et la sonde de Hall (3) sont disposés sensiblement de façon diamétralement opposée l'un par rapport à l'autre.

**2. -** Capteur selon la revendication 1, caractérisé en ce que l'écran magnétique comporte un secteur sensiblement cylindrique (8, 13) et deux pièces latérales (6, 7 ; 14, 15) en matériau magnétique, le secteur et les pièces étant solidaires entre eux et séparés par des entrefers (10, 11).

**3. -** Capteur selon la revendication 2, caractérisé en ce que le secteur et les pièces latérales sont rendus solidaires au moyen de pièces (9) en matériau amagnétique.

**4. -** Capteur selon l'une des revendications 2 ou 3, caractérisé en ce que les pièces latérales (6, 7) sont en forme de secteurs annulaires.

**5. -** Capteur selon l'une des revendications 2 ou 3, caractérisé en ce que les pièces latérales (14, 15) sont en forme de segments de cercles.

**6. -** Capteur selon la revendication 5, caractérisé en ce que en ce que les segments de cercle (6, 7) correspondent à une ouverture voisine d'un quart de cercle, pour mesurer le courant d'un conducteur primaire (2) avec des branches parallèles (2a, 2b ; 20) dont l'orientation peut varier entre une position sensiblement parallèle (2a, 2b) et une position sensiblement perpendiculaire (20) à un plan de fixation.

**7. -** Capteur selon l'une des revendications 2 à 6, caractérisé en ce que les pièces latérales (6, 7 ; 14, 15) recouvrent partiellement en projection le cercle de gorge (18) du tore.

**8. -** Capteur selon l'une des revendications 1 à 7, comportant un écran électrostatique radialement intérieur au tore en matériau amagnétique conducteur , caractérisé en ce que l'écran magnétique (5, 12) et l'écran électrostatique sont reliés par une liaison électrique en boucle ouverte à un potentiel de référence.
